# EUROPÄISCHE PATENTSCHRIFT

(11) **EP 3 198 731 B1**
(45) Veröffentlichungstag und Bekanntmachung des Hinweises auf die Patenterteilung: **28.11.2018**
(21) Anmeldenummer: 15771020.3
(22) Anmeldetag: 22.09.2015
(51) Int. Cl.: H04B 1/10, G06K 7/00, G06K 19/07, H04B 1/24, G06K 19/073, H03L 7/093, H03L 7/097, H03D 1/02

(54) **VERFAHREN UND SICHERHEITSMODUL ZUM EMPFANG VON ZWEI SIGNALEN**
METHOD AND SECURITY MODULE FOR RECEIVING TWO SIGNALS
PROCÉDÉ ET MODULE DE SÉCURITÉ PERMETTANT LA RÉCEPTION DE DEUX SIGNAUX

(30) Priorität: 26.09.2014 DE 102014014448
(43) Veröffentlichungstag der Anmeldung: 02.08.2017
(73) Patentinhaber: Giesecke+Devrient Mobile Security GmbH, 81677 München (DE)
(72) Erfinder: FINKENZELLER, Klaus, 85774 Unterföhring (DE); PFEIFFER, Florian, 85567 Grafing bei München (DE)
(86) Internationale Anmeldenummer: PCT/EP2015/001881
(87) Internationale Veröffentlichungsnummer: WO 2016/045787

(56) Entgegenhaltungen:
- US-A1- 2006 273 902
- US-A1- 2014 266 622
- US-A1- 2014 273 899

## Beschreibung

Die vorliegende Erfindung betrifft ein Verfahren, ein Sicherheitsmodul und ein System gemäß dem Oberbegriff der unabhängigen Ansprüche.

Insbesondere betrifft die vorliegende Erfindung ein Verfahren zum Erstellen eines Ausgabebitstromes für ein erstes Signal einer ersten Trägerfrequenz durch ein Sicherheitsmodul. Das Sicherheitsmodul empfängt ein Eingangssignal, umfassend das erste Signal und ein zweites Signal einer zweiten Trägerfrequenz. Das Eingangssignal wird mithilfe eines ersten nichtlinearen Bauteils demoduliert, wobei das erste nichtlineare Bauteil ein erstes Basisbandsignal ausgibt. Aus dem ersten Basisbandsignal wird ein erster Bitstrom generiert. Der erste Bitstrom wird einer Ausgabelogik zugeführt. Aus dem ersten Signal und dem zweiten Signal wird ein Mischsignal gebildet, wobei das Mischsignal das erste Signal auf der ersten Trägerfrequenz, das zweite Signal auf der zweiten Trägerfrequenz und ein Mischprodukt auf einer Zwischenfrequenz umfasst.

Weiterhin betrifft die vorliegende Erfindung ein Sicherheitsmodul, umfassend eine Empfangseinheit zum Empfangen eines ersten Signals einer ersten Trägerfrequenz und eines zweiten Signals einer zweiten Trägerfrequenz. Das Sicherheitsmodul umfasst ein erstes nichtlineares Bauteil und eine Pegelwertanpassungseinheit. Das erste nichtlineare Bauteil ist ausgebildet, aus dem ersten Signal und dem zweiten Signal ein erstes Basisbandsignal zu bilden, wobei die Pegelwertanpassungseinheit aus dem ersten Basisbandsignal einen ersten Bitstrom generiert.

Zum Empfang von Eingangssignalen und Demodulieren von Signalen, insbesondere durch ein kontaktloses Sicherheitsmodul, sind unterschiedliche Verfahren bekannt. Eine Empfangseinheit empfängt ein erstes Signal von einem Sende-/Empfangsgerät. Das empfangene erste Signal wird üblicherweise anhand eines Impedanzwandlers, insbesondere eine Vorrichtung und/ oder Einheit zur Vervielfachung einer Spannung, modifiziert. Über den Impedanzwandler wird eine Amplitude, insbesondere eine Spannungsamplitude, des empfangenen ersten Signals erhöht. Wenn es sich bei dem ersten Signal um ein amplitudenmoduliertes Signal handelt, wird mithilfe des Impedanzwandlers, der wenigstens ein nichtlineares Bauteil umfasst, das erste Signal demoduliert. Der Impedanzwandler ist üblicherweise ein Spannungsvervielfacher.

Zum Generieren eines Ausgabebitstroms aus dem ersten Signal wird es mittels einer Pegelwertanpassungseinheit verarbeitet. Die Pegelwertanpassungseinheit erstellt aus dem demodulierten ersten Signal einen Bitstrom des ersten Signals. Die Pegelwertanpassungseinheit umfasst üblicherweise die Funktion eines Komparators, womit das demodulierte erste Signal in ein binäres Signal umgewandelt wird. Das demodulierte erste Signal wird darüber hinaus in einem zweiten Strompfad mittels einer Glättungseinheit geglättet und davon ein Referenzwert für den Komparator gebildet. Der Referenzwert, der vorzugsweise kleiner als die Spitzenamplitude des demodulierten ersten Signals am Eingang der Pegelwertanpassungseinheit ist, gilt als Bezugswert gegenüber dem demodulierten ersten Signal zum Generieren des ersten Ausgabebitstromes. Die Pegelwertanpassungseinheit wertet somit das demodulierte erste Signal hinsichtlich des Referenzwertes aus.

Aufgrund stetigen Anstiegs drahtloser Kommunikation steigt die Anzahl von Signalen, die auf unterschiedlichen Trägerfrequenzen moduliert sind. Das kontaktlose Sicherheitsmodul empfängt oftmals neben dem ersten Signal weitere Signale, wenigstens aber ein zweites Signal. Besonders, wenn das zweite Signal eine zweite Trägerfrequenz aufweist, die nahe der ersten Trägerfrequenz des ersten Signals liegt und somit die erste Trägerfrequenz und die zweite Trägerfrequenz im gleichen Empfangsbereich des Sicherheitsmoduls sind und zudem das zweite Signal eine Amplitude in etwa der Größenordnung des ersten Signals oder größer aufweist, beeinflussen sich die beiden Trägerfrequenzen des ersten Signals und das zweite Signals gegenseitig derart, dass das Sicherheitsmodul aus dem Eingangssignal keinen eindeutigen Ausgabebitstrom betreffend das erste Signal generieren kann. Das Sicherheitsmodul generiert nur noch einen Störwert. Eine Kommunikation zwischen Sende-/Empfangsgerät und dem kontaktlosen Sicherheitsmodul ist nicht mehr sichergestellt.

Beispielsweise liegen die Frequenzbereiche von GSM und UHF-RFID nicht nur in unmittelbarer Nachbarschaft sondern überlappen sich teilweise. Beispielsweise senden ein UHF-RFID-Lesegerät im Frequenzbereich von 865 MHz und ein GSM-Mobiltelefon im Frequenzbereich von 880-915 MHz. Aufgrund einfacher Bauweise ist ein UHF-RFID-Transponder relativ breitbandig empfangsbereit. Der Empfangsbereich des UHF-RFID-Transponders ist gewöhnlich nur durch die Antenne begrenzt. Der UHF-RFID-Transponder kann sowohl UHF-RFID-Signale als auch GSM-Signale eines benachbarten Mobiltelefons empfangen. Beide Signale überlagern sich. Der UHF-RFID-Transponder des Standes der Technik kann die UHF-RFID-Signale nicht separieren und dekodieren. Eine Kommunikation zwischen dem UHF-RFID-Transponder und einem UHF-RFID-Sende-/Empfangsgerät ist nicht möglich, insbesondere sobald die Amplitude des GSM-Signals im Verhältnis zu dem UHF-RFID-Signal eine Grenzamplitude überschreitet.

Aus der US 2014/273899 A1 ist ein Verfahren und ein Kommunikationssystem zur Filterung und Dämpfung von GSM-Signalen in einem RFID-System bekannt. Die Vorrichtung besitzt ein UHF-Band RFID-System zur Verarbeitung eines ersten Übertragungssignals einer ersten Trägerfrequenz. Ein UHF-Band GSM-System weist einen Schaltkreis zur Verarbeitung eines zweiten Übertragungssignals einer zweiten Trägerfrequenz auf. Ein Tiefpassfilter des RFID-Systems dient als Bandpass und dämpft harmonische Komponenten des GSM-Trägersignals. Verzerrungen des RFID-Signals durch das GSM-Signal werden unterdrückt, wenn beide Trägersignale nahe beieinander liegen.
Aufgabe der Erfindung ist, die Nachteile des Standes der Technik zu beheben. Insbesondere ist es Aufgabe, einen verbesserten Empfang eines Sicherheitsmoduls bereitzustellen, wodurch eine Kommunikation zwischen einem Sende-/Empfangsgerät und dem Sicherheitsmodul bei Empfang wenigstens eines zweiten Signals im gleichen Empfangsbereich wie das erste Signal möglich ist.

Diese Aufgabe wird mit einem Verfahren, einem Sicherheitsmodul und einem System gemäß den unabhängigen Ansprüchen gelöst. Vorteilhafte Ausgestaltungen sind in den Unteransprüchen aufgeführt.

Bei einem erfindungsgemäßen Verfahren zum Erstellen eines Ausgabebitstromes für ein erstes Signal einer ersten Trägerfrequenz durch ein Sicherheitsmodul empfängt das Sicherheitsmodul ein Eingangssignal, umfassend das erste Signal und ein zweites Signal, wobei das erste Signal und das zweite Signal zusammen, d.h. gleichzeitig, empfangen werden. Das Eingangssignal wird durch ein erstes nichtlineares Bauteil demoduliert und ein erstes Basisbandsignal generiert. Aus dem ersten Basisbandsignal wird ein erster Bitstrom generiert. Der erste Bitstrom wird einer Ausgabelogik zugeführt. Weiterhin wird ein Mischsignal gebildet, welches das erste Signal auf der ersten Trägerfrequenz, das zweite Signal auf der zweiten Trägerfrequenz und ein Mischprodukt auf einer Zwischenfrequenz aufweist.

Gemäß der Erfindung wird das Mischprodukt mittels eines zweiten nichtlinearen Bauteils demoduliert, wobei ein zweites Basisbandsignal erhalten wird. Aus dem zweiten Basisbandsignal wird ein zweiter Bitstrom betreffend das erste Signal im Mischprodukt generiert. Die Ausgabelogik erstellt einen Ausgabebitstrom, wobei die Ausgabelogik entweder den ersten Bitstrom oder den zweiten Bitstrom als Ausgabebitstrom für das erste Signal auswählt.

Aufgrund unterschiedlicher Trägerfrequenzen der ersten Trägerfrequenz und der zweiten Trägerfrequenz wird durch das erste nichtlineare Bauteil ein Mischsignal gebildet. In dem Mischsignal sind Mischprodukte des ersten und zweiten Signals enthalten. Die Mischprodukte sind auf Zwischenfrequenzen (k x f1 + m x f2) sowie |k x f1 - m x f2| mit k, m = 0, 1, 2, 3, .... Mit Abstand der Zwischenfrequenzen von den Trägerfrequenzen steigt die Ordnung der Zwischenfrequenz. D.h., die erste Ordnung gilt für k + m = 2. Die Zwischenfrequenzen erster Ordnung wären z.B. 2 x f1, 2 x f2, 1 x f1 + 1 x f2 und |f1 - f2|. Die Zwischenfrequenzen zweiter Ordnung (k + m = 3) gilt beispielsweise für die Zwischenfrequenzen 3 x f1, 3 x f2, 2 x f1 + 1 x f2, 1 x f1 + 2 x f2, |1 x f1 + 2 x f2| und |2 x f1 + 1 x f2|. Als Zwischenfrequenz sind somit ganzzahlige Vielfache von Summen und Differenzen der ersten und zweiten Trägerfrequenz möglich. Zwischenfrequenzen sind ähnlich Seitenbänder; sie sind jedoch auch ein ganzzahliges vielfaches der Trägerfrequenzen der Seitenbänder. Bei der Zwischenfrequenz kann es sich um genau eine Frequenz handeln. Eine Zwischenfrequenz kann auch ein Frequenzspektrum bzw. einen Frequenzbereich festlegen, in dem das Mischprodukt auftritt. Zum Beispiel kann die Trägerfrequenz des ersten und/ oder zweiten Signals innerhalb festgelegter Grenzen sein. Beispielsweise handelt es sich bei dem ersten und/ oder zweiten Signal um ein Signal mit einer möglichen Trägerfrequenz in einem Frequenzbereich von 880 MHz bis 915 MHz. Die Amplitude der Mischprodukte ist im Wesentlichen eine Summe aus den Pegeln des ersten und zweiten Signals sowie einen konstanten Faktor. Der Verlauf des ersten Signals ist im Mischprodukt enthalten. Insbesondere der Verlauf eines amplituden- oder frequenzmodulierten ersten Signals bleibt erhalten. Eine Überlagerung der ersten und zweiten Trägerfrequenz ist im Mischprodukt nicht enthalten. Die Amplitude der Mischprodukte sinkt mit steigender Ordnung. Somit weisen Mischprodukte erster Ordnung die größte Amplitude auf. Jedes der Mischprodukte kann mit dem zweiten Demodulator, der zum Demodulieren des ersten Signals geeignet ist, ohne Beeinflussung durch das zweite Signal demoduliert werden.

Vorzugsweise handelt es sich beim ersten Signal um ein amplitudenmoduliertes Signal, beispielsweise ein UHF-RFID-Signal und beim zweiten Signal um ein GMSK-moduliertes Signal.

Grundsätzlich kann das Sicherheitsmodul in einem tragbaren Datenträger, nachfolgend auch Tag genannt, wie einer Chipkarte, einer sicheren Massenspeicherkarte oder einem USB-Token, verkörpert sein. Beispielsweise kann das Sicherheitsmodul eine Identitätskarte und/ oder eine Fahrkarte sein. Das Sicherheitsmodul kann die Form eines Etiketts, nachfolgend aufweisen. Es kann auch fest in einem Modul oder Körper eingebaut, wie ein Trusted Platform Module (TPM), ein M2M-Modul, ein Benutzer-Identifikations-Modul oder ein Decoder-Modul, sein. Das Sicherheitsmodul kann zur Integration in einem Notebook, Handy, Computer oder Tastatur vorgesehen sein. Vorzugsweise weist das Sicherheitsmodul einen Prozessor und einen Speicher auf. Das Sicherheitsmodul ist insbesondere zur Kommunikation über eine Luftschnittstelle, bspw. in einem Frequenzbereich von RFID, insbesondere UHF-RFID, ausgebildet. Das Sicherheitsmodul kann als UHF-RFID-Transponder ausgebildet sein.

Ein Sende-/Empfangsgerät, nachfolgend auch Sender benannt, dient zur Kommunikation mit dem Sicherheitsmodul. Das Sende-/Empfangsgerät kann ein Kartenleser, insbesondere als mobile Einheit, beispielsweise als Zubehör an einem Kassensystem, an einem Computer oder einem Mobiltelefon, als festinstalliertes Gerät, insbesondere zur Zugangskontrolle, oder als integrierte Einheit in einem Notebook, Mobiltelefon, Computer oder Tastatur vorgehalten sein.

Bei einem nichtlinearen Bauteil handelt es sich um ein elektrisches und/ oder elektronische Bauteil mit einer nichtlinearen Beziehung zwischen Strom und Spannung. Eine Strom-Spannungs-Kennlinie verläuft unlinear. Bei einem nichtlinearen Bauteil kann es sich lediglich um ein einzelnes nichtlieares Bauelement oder auch um ein nichtlineares Netzwerk handeln. Das nichtlineare Netzwerk umfasst Bauelemente, deren Zusammenschaltung im Gesamten eine nichtlineare Strom-Spannungs-Kennlinie ergibt. Ein nichtlineares Bauteil kann eine Gleichrichterdiode, d.h. ein P-N-Übergang, ein Collector-Emitter-Übergang eines Transistors oder eine Röhre sein. Ein nichtlineares Netzwerk kann eine Zusammenschaltung von Gleichrichterdioden sein. Beispielsweise ist ein Spannungsvervielfacher mit Diodenschaltung ein nichtlineares Netzwerk.

Mit der vorliegenden Erfindung ist es nunmehr unter anderem möglich, in der Nähe eines UHF-RFID-Transponders ein Mobilfunktelefon unter Nutzung von GSM-Diensten zu betreiben, ohne die Kommunikation zwischen UHF-RFID-Sende-/Empfangsgerät und dem UHF-RFID-Transponder zu beeinflussen, insbesondere stören. Somit kann der UHF-RFID-Transponder nicht durch GSM-Signale in seiner Kommunikation negativ beeinträchtigt, insbesondere gestört, werden.

In einer Ausführungsform kann vorgesehen sein, dass die Ausgabelogik den ersten Bitstrom mit dem zweiten Bitstrom kombiniert. Sobald die Ausgabelogik erkennt, dass das Sicherheitsmodul das zweite Signal empfängt, wechselt die Ausgabelogik zum Ausgeben des Ausgabebitstromes für das erste Signal vom ersten Bitstrom auf den zweiten Bitstrom. Während des Wechselns findet ein unterbrechungsfreier Übergang vom ersten auf den zweiten Bitstrom und umgekehrt statt. Der Ausgabebitstrom entspricht dem Bitstrom des ersten Signals; d. h., der Ausgabebitstrom gibt die im ersten Signal enthaltenen Daten wieder. Eine Unterbrechung oder ein Fehler im Ausgabebitstrom, insbesondere Fehlerbits oder fehlende Bits, sind nicht vorhanden.

Das Mischsignal kann mithilfe eines Frequenzfilters gefiltert werden. Das Frequenzfilter ist auf wenigstens eine vorher bestimmte Zwischenfrequenz ausgelegt. Unerwünschte Frequenzanteile werden herausgefiltert. Das Frequenzfilter gibt entsprechend seiner Auslegung vorzugsweise lediglich ein Mischprodukt aus dem Mischsignal aus. Das Frequenzfilter kann ein Bandpassfilter sein. Mit dem Frequenzfilter können Mischprodukte von Eingangssignalen aus einem, insbesondere eng, begrenzten Frequenzbereich durchgelassen werden. Das Frequenzfilter kann schmalbandig auf eine vorbestimmte Frequenz oder einen vorbestimmten Frequenzbereich unabhängig einer möglichen Zwischenfrequenz ausgelegt sein. Weiterhin kann das Frequenzfilter als Hochpassfilter ausgebildet sein. Hierbei kann das Verhalten eines realen Hochpassfilters zusammen mit der Bildung von Amplituden in Mischprodukten höherer Ordnung ausgenutzt werden, so dass schließlich nur ein Mischprodukt durchgelassen wird. Es kann sichergestellt werden, dass nur ein bestimmtes Mischprodukt auf einer Zwischenfrequenz dem zweiten nichtlinearen Bauteil zugeführt wird.

In einer Ausführungsform kann vorgesehen sein, dass das erste und/oder zweite nichtlineare Bauteil neben der Ausgabe eines ersten und/ oder zweiten Basisbandsignals die Amplitude des Eingangssignals, des ersten und/ oder zweiten Signals erhöht. Das zweite nichtlineare Bauteil kann die Amplitude des Mischprodukts erhöhen. Weiterhin kann das erste und/oder zweite nichtlineare Bauteil die Funktion eines Mischers und/oder eines Demodulators umfassen. Anhand der Funktion des Mischers werden aus dem ersten und zweiten Signal unterschiedlicher Trägerfrequenzen Mischprodukte auf wenigstens eine der oben aufgeführten Zwischenfrequenzen generiert.

In einer Ausführungsform kann eine erste und/oder zweite Pegelwertanpassungseinheit den ersten bzw. zweiten Bitstrom aus dem ersten bzw. zweiten Basisbandsignal generieren. Dazu kann das erste Basisbandsignal der ersten Pegelwertanpassungseinheit zugeführt werden. Weiterhin kann der zweiten Pegelwertanpassungseinheit das zweite Basisbandsignal zugeführt werden. Die erste und/ oder zweite Pegelwertanpassungseinheit generiert mit Bezug auf einen ersten bzw. zweiten Referenzwert den ersten bzw. zweiten Bitstrom. Der erste bzw. zweite Referenzwert ist vorzugsweise ein konstanter Wert, insbesondere ein Gleichspannungswert. Der erste bzw. zweite Referenzwert kann durch eine Konstantspannungsquelle, beispielsweise mithilfe einer Z-Diode, gebildet werden. Weiterhin kann der erste bzw. zweite Referenzwert, beispielsweise über eine übliche Gleichrichterdiode sowie einer Glättungsschaltung, umfassend einen Kondensator, aus dem ersten und/oder zweiten Basisbandsignal gewonnen werden. Vorzugsweise passt sich der erste bzw. zweite Referenzwert an das erste bzw. zweite Basisbandsignal an. D.h., wenn das erste und/ oder zweite Basisbandsignal eine Änderungen der Grundamplitude (Gleichspannungsanteil) erfährt, ändert sich der erste bzw. zweite Referenzwert entsprechend. Beispielsweise liegt die Grundamplitude des ersten Basisbandsignals bei 0,7V, wobei Spitzenamplituden einen Wert von 1,3V aufweisen können. Analog kann der erste bzw. zweite Referenzwert vom Mischsignal, dem ersten Signal und oder dem zweiten Signal abhängen.

Die erste und/ oder zweite Pegelwertanpassungseinheit kann einen Komparator für einen Abgleich des ersten bzw. zweiten Basisbandsignals im Verhältnis zu dem ersten bzw. zweiten Referenzwert umfassen. Mit der ersten und/oder zweiten Pegelwertanpassungseinheit kann ein Schwellwert des ersten bzw. zweiten Basisbandsignals zur Ausgabe des ersten bzw. zweiten Bitstromes festgelegt werden, z. B. ob es sich bei der Amplitude des ersten bzw. zweiten Basisbandsignals um eine logische "1" oder logische "0" handelt. Mit anderen Worten wird mithilfe des ersten und/ oder zweiten Referenzwertes eine Schwelle zum Generieren des ersten und/ oder zweiten Bitstromes festgelegt.

Die Ausgabelogik kann vom ersten Bitstrom auf den zweiten Bitstrom wechseln, wenn das Sicherheitsmodul das zweite Signal empfängt. Dazu kann die Ausgabelogik eine Detektionseinheit umfassen, welche das Eingangssignal auf den Empfang des zweiten Signals untersucht. Bei Empfang des zweiten Signals wechselt die Ausgabelogik auf den zweiten Bitstrom.

Weiterhin kann die Ausgabelogik den ersten Bitstrom und zweiten Bitstrom, d.h. insbesondere den Eingang der Ausgabelogik analysieren. Falls das zweite Signal empfangen wird, ergibt sich am Ausgang des zweiten nichtlinearen Bauteils ein Ausgangssignal und gegebenenfalls am Eingang der Ausgabelogik für den ersten Bitstrom im ersten Bitstrom ein Störwert. Entsprechend veranlasst die Ausgabelogik den Wechseln bzw. das Umschalten vom ersten Bitstrom auf den zweiten Bitstrom.

Vorzugsweise wird das Mischprodukt nur dann gebildet, wenn das zweite Signal empfangen wird. Somit ergibt sich am Ausgang der zweiten Pegelanpassungseinheit und somit im zweiten Bitstrom nur dann ein relevanter Signalverlauf, wenn das zweite Signal vom Sicherheitsmodul empfangen wird. Die Ausgabelogik kann den zweiten Bitstrom prüfen, ob der zweite Bitstrom einen gültigen Signalverlauf umfasst. Entsprechend dem Prüfergebnis kann die Ausgabelogik den Wechsel vom ersten auf den zweiten Bitstrom und umgekehrt veranlassen. Die Ausgabelogik kann die Plausibilität des Signalverlaufs des ersten und/ oder zweiten Bitstroms prüfen.

Üblicherweise wird das erste Signal zur Energieversorgung des Sicherheitsmoduls verwendet. Nachdem das zweite Signal ebenfalls vom Sicherheitsmodul empfangen wird, kann in einer Ausführungsform vorgesehen sein, dass das Sicherheitsmodul die Energie des zweiten Signals ebenfalls zu seiner Energieversorgung hinzuzieht. Insbesondere kann vorgesehen sein, dass das zweite Signal als Hauptenergieträger verwendet wird und das zweite Signal vom Sicherheitsmodul als Informationsträger ignoriert wird.

In einer Ausführungsform kann vorgesehen sein, dass das Sicherheitsmodul eine Empfangseinheit umfasst. Die Empfangseinheit des Sicherheitsmoduls umfasst insbesondere eine Antenne. Die Empfangseinheit ist für einen Empfangsbereich ausgebildet, d.h. zum Empfang von Signalen in einem bestimmten Frequenzspektrum. Die erste Trägerfrequenz des ersten Signals und die zweite Trägerfrequenz des zweiten Signals gehören diesem Frequenzspektrum an. Insbesondere wenn die erste und zweite Trägerfrequenz spektral eng zusammen liegen, bspw. UHF-RFID und GSM, kann die Empfangseinheit die Signale der ersten und zweiten Trägerfrequenz empfangen und weiterverwerten. Das erfindungsgemäße Verfahren ist besonders vorteilhaft in einer Anwendung für UHF-RFID-Sicherheitsmodule in Umgebung von GSM-Signalen.

Ein erfindungsgemäßes Sicherheitsmodul umfasst eine Empfangseinheit zum Empfangen des ersten Signals einer ersten Trägerfrequenz und eines zweiten Signals einer zweiten Trägerfrequenz. Weiterhin umfasst das Sicherheitsmodul ein erstes nichtlineares Bauteil. Das erste nichtlineare Bauteil ist ausgebildet, aus dem empfangenen ersten und zweiten Signal ein Mischsignal zu bilden. Das Mischsignal weist ein erstes Basisbandsignal auf. Eine erste Pegelwertanpassungseinheit generiert aus dem ersten Basisbandsignal einen ersten Bitstrom. Darüber hinaus weist das Sicherheitsmodul ein erstes Frequenzfilter, ein zweites nichtlineares Bauteil und eine Ausgabelogik auf. Das Frequenzfilter ist ausgebildet, aus dem Mischsignal des ersten nichtlinearen Bauteils ein Mischprodukt zu filtern. Das zweite nichtlineare Bauteil ist ausgebildet, das Mischprodukt zu demodulieren und vorzugsweise eine Amplitude des Mischprodukts zu erhöhen. Die Ausgabelogik weist einen Eingang für den ersten Bitstrom und einen Eingang für den zweiten Bitstrom auf, so dass das demodulierte Mischprodukt als zweiter Bitstrom der Ausgabelogik zugeführt wird. Die Ausgabelogik ist ausgebildet, zwischen dem ersten und dem zweiten Bitstrom zu wechseln und aus dem ersten und zweiten Bitstrom einen Bitstrom des ersten Signals zu bilden.

Das erfindungsgemäße Sicherheitsmodul umfasst demnach zwei nichtlineare Bauteile. Zur Demodulation des ersten Signals demoduliert das erste nichtlineare Bauteil das Eingangssignal und das zweite nichtlineare Bauteil demoduliert lediglich ein Mischprodukt des Eingangssignals hinsichtlich des Signalverlaufs des ersten Signals. Die Ausgabelogik ist ausgebildet, zwischen dem ersten Bitstrom und dem zweiten Bitstrom zur Ausgabe des Bitstromes des ersten Signals zu wechseln. Der Wechsel erfolgt in Abhängigkeit, ob das zweite Signal vom Sicherheitsmodul empfangen wird. Mithilfe des Frequenzfilters wird, sofern das zweite Signal empfangen wird, von dem Mischsignal lediglich ein Mischprodukt herausgefiltert, und zur weiteren Verarbeitung, insbesondere der Demodulation bezüglich des ersten Signals, verwendet.

In einer vorteilhaften Ausgestaltung kann das Frequenzfilter ein Bandpassfilter sein. Das Bandpassfilter ist besonders geeignet, Signale eines Frequenzbandes, d.h. eines bestimmten Frequenzspektrums, passieren zu lassen. Das Frequenzband entspricht vorzugsweise einer oben beschriebenen Zwischenfrequenz eines Mischprodukts. Insbesondere kann das Frequenzfilter als Tiefpassfilter oder Hochpassfilter ausgebildet sein.

Wie bereits beschreiben übernimmt das erste und/ oder zweite nichtlineare Bauteil die Funktion eines Demodulators, wobei gegebenenfalls die erste und/oder zweite Pegelwertanpassungseinheit zur Generierung des ersten und/ oder zweiten Bitstromes hinzugezogen werden kann.

Ein erfindungsgemäßes System ist zur Ausführung eines Verfahrens oder mit einem Sicherheitsmodul, wie bereits ausgeführt, ausgebildet.

Die Erfindung wird im Folgenden noch weiter beispielhaft an Hand der Zeichnungen erläutert. Es zeigen:
- Fig. 1a: ein Blockschaltbild eines Ausführungsbeispiels gemäß der Erfindung;
- Fig. 1b: eine Darstellung eines Signalverlaufs zum Blockschaltbild der Fig. 1a;
- Fig. 2: ein schematisiertes Frequenzdiagramm gemäß der Erfindung;
- Fig. 3: ein weiteres Ausführungsbeispiel gemäß der Erfindung;
- Fig. 4: ein weiteres Ausführungsbeispiel gemäß der Erfindung;
- Fig. 5a: ein Anwendungsbeispiel für den Einsatz der Erfindung zur Reichweitenerhöhung von Sicherheitsmodulen;
- Fig. 5b: ein Ausführungsbeispiel zur Steuerung der Reichweitenerhöhung; und
- Fig. 6: eine Steuerungsschema des Anwendungsbeispiels aus Fig. 5a.

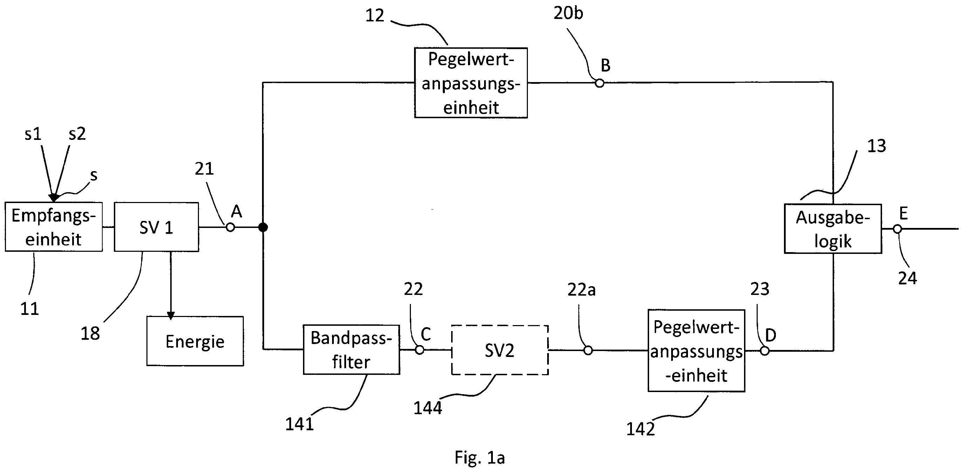

In der Fig. 1a ist ein Blockschaltbild zu einem Ausführungsbeispiel eines Verfahrens gemäß der Erfindung dargestellt.

Eine Empfangseinheit 11 empfängt ein Eingangssignal s. Das Eingangssignal s umfasst ein erstes Signal s1 und ein zweites Signal s2. Das erste Signal s1 ist in diesem Ausführungsbeispiel ein UHF-RFID-Signal auf einer ersten Trägerfrequenz f1 von ca. 865 MHz. Das zweite Signal s2 ist ein GSM-Signal auf einer zweiten Trägerfrequenz f2 von ca. 915 MHz. Das Eingangssignal s wird von der Empfangseinheit 11 an ein erstes nichtlineares Bauteil 18, vorliegend ein erster Spannungsvervielfacher (SV 1) 18, weitergegeben. Der Einfachheit wegen und zum besseren Verständnis wird nachfolgend lediglich der erste Spannungsvervielfacher 18 anstatt des ersten nichtlinearen Bauteils 18 erwähnt. Der erste Spannungsvervielfacher 18 ist ähnlich einer Ladungspumpe aufgebaut und umfasst eine Zusammenschaltung von Dioden und Kondensatoren. Dieser erste Spannungsvervielfacher 18 weist aufgrund seiner unlinearen Kennlinie die Funktion eines elektronischen Mischers auf.

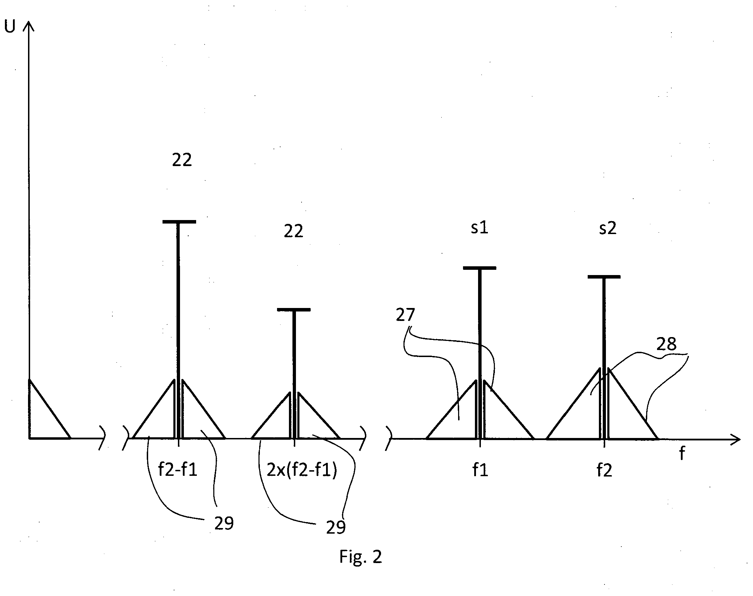

Der erste Spannungsvervielfacher 18 generiert aus dem Eingangssignal s ein Mischsignal 21. Das Mischsignal 21 weist in einem ersten Basisbandsignal sowohl das erste Signal s1 auf seiner ersten Trägerfrequenz f1 als auch das zweite Signal s2 auf seiner zweiten Trägerfrequenz f2 auf. Weiterhin sind in dem Mischsignal 21 Mischprodukte des ersten und zweiten Signals s1, s2 enthalten (vgl. Fig. 2). Mischprodukte sind Signale auf Zwischenfrequenzen, welche durch die erste und zweite Trägerfrequenz f1, f2 festgelegt werden. Der erste Spannungsvervielfacher 18 demoduliert das Eingangssignal s. Das Mischsignal 21 wird einer ersten Pegelwertanpassungseinheit 12 weitergeleitet. Die erste Pegelwertanpassungseinheit 12 wertet das Mischsignal 21 in Bezug auf einen ersten Referenzwert aus und generiert basierend auf den ersten Referenzwert aus dem Mischsignal 21 einen ersten Bitstrom 20b.

Parallel zur ersten Pegelwertanpassungseinheit 12 wird das Mischsignal 21 an einen Frequenzfilter 141, welcher in diesem Ausführungsbeispiel ein Bandpassfilter 141 für tiefe Frequenzen ist, an ein zweites nichtlineares Bauteil 144, vorliegend einen zweiten Spannungsvervielfacher (SV2) 144, und an eine zweite Pegelwertanpassungseinheit 142 weitergeleitet. Das Frequenzfilter 141, der zweite Spannungsvervielfacher 144 und die zweite Pegelwertanpassungseinheit 142 sind hintereinander geschaltet. Zum besseren Verständnis und leichteren Lesbarkeit wird im Folgenden das zweite nichtlineare Bauteil 144 als zweiter Spannungsvervielfacher 144 bezeichnet.

Das Bandpassfilter 141 ist für ein Mischprodukt 22 mit der Trägerfrequenz |(f2-f1)| und somit für 50 MHz konfiguriert. Gleichzeitig ist das erste Mischprodukt 22 aus dem Mischsignal 21 das Mischprodukt mit der niedrigsten (ersten) Ordnung und in der Regel das Mischprodukt mit der höchsten Amplitude. Das Bandpassfilter 141 stellt sicher, dass ausschließlich das erste Mischprodukt 22 ausgegeben wird. Andere Anteile, insbesondere Mischprodukte, im Mischsignal 21 werden herausgefiltert.

Das erste Mischprodukt 22 wird dem zweiten Spannungsvervielfacher 144 zugeführt, wobei die Amplitude des ersten Mischprodukts 22 zusätzlich durch den zweiten Spannungsvervielfacher 144 verstärkt wird. Der zweite Spannungsvervielfacher 144 ist ebenfalls ähnlich einer Ladungspumpe aufgebaut. Der zweite Spannungsvervielfacher 144 demoduliert das erste Mischprodukt 22 entsprechend des Modulationsverfahrens des ersten Signals s1 und gibt ein zweites Basisbandsignal 22a aus. Die zweite Pegelwertanpassungseinheit 142 generiert aus dem zweiten Basisbandsignal 22a in Bezug auf einen zweiten Referenzwert einen zweiten Bitstrom 23. Der zweite Bitstrom 23 und der erste Bitstrom 20b werden einer Ausgabelogik 13 zugeführt. Die Ausgabelogik 13 kombiniert den ersten Bitstrom 20b und den zweiten Bitstrom 23. Die Ausgabelogik 13 gibt einen Ausgabebitstrom 24 des ersten Signals s1 aus.

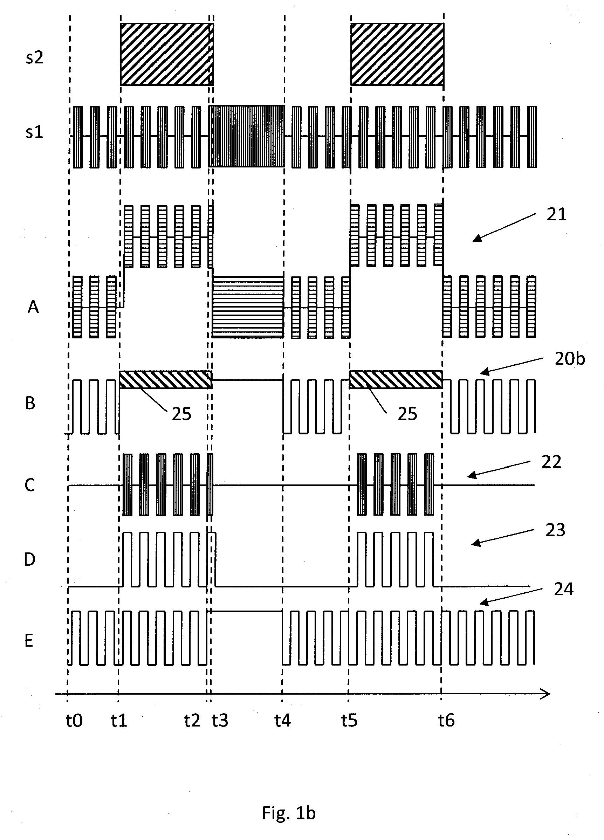

Nachfolgend wird das Wirkprinzip der Erfindung anhand des Blockschaltbildes aus Fig. 1a mit den in Fig. 1b dargestellten Signalverläufen veranschaulicht. Die Fig. 1b zeigt Signalverläufe an Messpunkte A bis E sowie der Signale s1 und s2 zu Zeitpunkte t0 bis t6. Vorrangig soll die Signalverarbeitung erläutert werden.

In dem Zeitbereich t0-t1 empfängt die Empfangseinheit 11 lediglich das erste Signal s1. Dies bedeutet, das Mischsignal 21 am Ausgang des ersten Spannungsvervielfachers 18 umfasst lediglich ein einziges Signal, nämlich das erste Signal s1 auf seiner ersten Trägerfrequenz f1. Somit sind keine Mischprodukte im Mischsignal 21 enthalten. Der erste Spannungsvervielfacher 18 demoduliert das erste Signal aus dem Eingangssignal s (siehe Signalverlauf Messpunkt A). D. h., das erste Basisbandsignal im Mischsignal 21 weist den demodulierten Signalverlauf des ersten Signals s1 auf. Die erste Pegelwertanpassungseinheit 12 gibt den ersten Bitstrom 20b aus, der dem Bitstrom des ersten Signals s1 (vgl. Signalverlauf Messpunkt B) entspricht.

Das Mischsignal 21 weist keine Mischprodukte auf Zwischenfrequenzen auf. Der Ausgang des Bandpassfilters 141 filtert kein Mischprodukt auf einer Zwischenfrequenz und zeigt an seinem Ausgang keinen Signalverlauf, d.h. ein Null-Signal, auf (vgl. Signalverlauf Messpunkt C). Der zweite Spannungsvervielfacher 144 erhält kein Eingangssignal. Entsprechend generiert der zweite Spannungsvervielfacher 144 kein Signal. Die zweite Pegelwertanpassungseinheit 142 erhält kein Eingangssignal. Der zweite Bitstrom 23 ist somit Null (vgl. Signalverlauf Messpunkt D). Die Ausgabelogik 13 gibt den ersten Bitstrom 20b als Ausgabebitstrom 24 des ersten Signals s1 aus.

Im Zeitintervall t1-t2 empfängt die Empfangseinheit 11 sowohl das erste Signal s1 als auch das zweite Signal s2, z. B. einen GSM-Burst. Das Mischsignal 21 (vgl. Signalverlauf Messpunkt A) umfasst das erste und zweite Signal s1 und s2 sowie deren Mischprodukte. Der erste Spannungsvervielfacher 18 gibt keinen eindeutigen Signalfluss aus. Insbesondere liefert der erste Spannungsvervielfacher 18 ein Mischsignal 21 mit gestörtem/ verunreinigtem Spannungsverlauf. Beispielsweise umfasst das Mischsignal 21 das erste Signal s1 mit einem DC-Offset unbekannter Höhe, wobei zusätzlich Mischprodukte den Verlauf des Mischsignals 21 verunreinigen. Die erste Pegelwertanpassungseinheit 12 kann aus dem des Mischsignals 21 kein eindeutiges Binärsignal, insbesondere keinen Bitstrom, generieren. Die Pegelwertanpassungseinheit 12 gibt im ersten Bitstrom 20b eine Störung 25 aus (vgl. Signalverlauf Messpunkt B).
Das Mischsignal 21 liegt am Bandpassfilter 141 an. Das Bandpassfilter 141 ist zum Filtern eines ersten Mischprodukts 22 erster Ordnung (f2-f1) konfiguriert. Am Ausgang des Bandpassfilters 141 liegt deshalb nur das erste Mischprodukt 22 erster Ordnung an (vgl. Signalverlauf Messpunkt C). Dieses erste Mischprodukt 22 erster Ordnung wird durch den zweiten Spannungsvervielfacher 144 demoduliert und deren Amplitude erhöht. Der zweite Spannungsvervielfacher 144 gibt das zweite Basisbandsignal 22a aus. Die zweite Pegelwertanpassungseinheit 142 generiert basierend auf dem zweiten Basisbandsignal 22a den zweiten Bitstrom 23 (vgl. Signalverlauf Messpunkt D). Der zweite Bitstrom 23 entspricht dem demodulierten Bitstrom des ersten Signals s1. Der zweite Bitstrom 23 wird der Ausgabelogik 13 gemeinsam mit dem ersten Bitstrom 20b zugeführt. Die Ausgabelogik 13 erkennt im ersten Bitstrom die Störung 25 und wechselt vom ersten Bitstrom 20b auf den gefilterten zweiten Bitstrom 23.

Die Empfangseinheit 11 hat während des Zeitintervalls t0 bis t2 ein moduliertes erstes Signal s1 empfangen. Während des Zeitintervalls t2-t3 empfängt die Empfangseinheit 11 aber ein erstes Signal s1, das hinsichtlich einer Amplitudenmodulation zu 100% unmoduliert ist. Das zweite Signal s2 mit einer Trägerfrequenz von 915 MHz wird weiterhin empfangen. Aufgrund des zweiten Signals s2 weist der erste Bitstrom 20b am Ausgang der ersten Pegelwertanpassungseinheit 12 weiter das Störsignal 25 (vgl. Signalverlauf Messpunkt B) auf. Das Bandpassfilter 141 filtert das Mischsignal 21, so dass der Ausgang des Bandpassfilters 141 das erste Mischprodukt 22 erster Ordnung (vgl. Signalverlauf Messpunkt C) aufweist. Der zweite Spannungsvervielfacher 144 demoduliert das erste Mischprodukt 22, erhöht dessen Amplitude und gibt entsprechend ein zweites Basisbandsignal 22a an die zweite Pegelwertanpassungseinheit 142 aus. Die zweite Pegelwertanpassungseinheit 142 generiert aus dem zweiten Basisbandsignal 22a hinsichtlich des ersten Signals s1 den zweiten Bitstrom 23 (vgl. Signalverlauf Messpunkt D). Die Pegelwertanpassungseinheit 142 gibt den zweiten Bitstrom 23 an die Ausgabelogik 13 aus. Der zweite Bitstrom 23 entspricht für das Zeitintervall t2-t3 dem Verlauf des Bitstroms des ersten Signals s1. Die Ausgabelogik 13 erkennt aus dem Störsignal 25 im ersten Bitstroms 20b, dass das zweite Signal s2 von der Empfangseinheit 11 empfangen wird und gibt weiterhin den zweiten Bitstrom 23 als Ausgabebitstrom 24 des ersten Signals s1 (vgl. Signalverlauf Messpunkt E) aus.

Im Zeitintervall t3-t4 liegt das erste Signal s1 weiterhin hinsichtlich einer Amplitudenmodulation zu 100% unmoduliert vor. Das zweite Signal s2 ist zum Zeitpunkt t3 weggebrochen, so dass die Empfangseinheit 11 kein zweites Signal s2 empfängt. Das Mischsignal 21 umfasst lediglich das erste Signal s1 auf seiner Trägerfrequenz f1. Der erste Spannungsvervielfacher 18 demoduliert das Mischsignal 21 bzw. erste Signal s1. Die erste Pegelwertanpassungseinheit 12 gibt als ersten Bitstrom 20b das demodulierte erste Signal s1 aus (vgl. Messpunkt B). Entsprechend dem ersten Signal s1 ist dieser Teilverlauf des ersten Bitstroms 20b logisch "1". Im Mischsignal 21 sind keine Mischprodukte enthalten. Dementsprechend gibt das Bandpassfilter 141 kein Mischprodukt 22 erster Ordnung aus (vgl. Messpunkt C). Der zweite Spannungsvervielfacher 144 gibt entsprechend kein zweites Basisbandsignal 22a aus. Die zweite Pegelwertanpassungseinheit 142 generiert keinen zweiten Bitstrom 23. Die Ausgangslogik 24 gibt als Ausgabebitstrom 24 am Messpunkt E den ersten Bitstrom 20b aus.

Während des Zeitintervalls t4-t5 empfängt die Empfangseinheit 11 nur das erste Signal s1. Eine Signalverarbeitung findet analog zum Zeitintervall t0-t1 statt.

Während des Zeitintervalls t5-t6 empfängt die Empfangseinheit 11 sowohl das erste Signal s1 auf seiner ersten Trägerfrequenz f1 als auch das zweite Signal s2 auf seiner zweiten Trägerfrequenz f2. Dies bewirkt am Ausgang des ersten Spannungsvervielfachers 18 ein Mischsignal 21 analog zum Zeitintervall t1-t2. Eine Signalverarbeitung wird entsprechend der Beschreibung zum Zeitintervall t1-t2 vorgenommen.

In der dem Zeitpunkt t6 nachfolgenden Zeit empfängt die Empfangseinheit 11 lediglich das erste Signal s1. Eine Signal verarbeitung wird analog der Beschreibung des Zeitintervalls t0-t1 durchgeführt.

Ab dem Zeitpunkt t0 entspricht der Verlauf des Ausgabebitstromes 24 dem Verlauf des Bitstromes des ersten Signals s1. Obwohl das zweite Signal s2 von der Empfangseinheit 11 empfangen wird und das zweite Signal s2 als Störsignal zum Generieren des Bitstromes 24 des ersten Signals s1 anzusehen ist, kann der Bitstrom 24 des ersten Signals s1 gewonnen werden.
In der Figur 2 ist zur Verdeutlichung der Erfindung das Mischsignal 21 aus den Figuren 1a, 1b auszugsweise dargestellt. Das Mischsignal 21 umfasst das erste Signal s1 auf der ersten Trägerfrequenz f1 von 865 MHz sowie das zweite Signal s2 auf der zweiten Trägerfrequenz f2 von 915 MHz. Die erste und zweite Trägerfrequenz f1, f2 liegen auf dem gleichen Frequenzband, sind nicht gleich, entsprechen jedoch sich ungefähr (f1 ≠ f2 ∧ f1 ≈ f2). Weiterhin sind auf Zwischenfrequenzen Mischprodukte 22 aus dem ersten und zweiten Signal s1, s2 mit einer ersten Zwischenträgerfrequenz f2-f1 und einer zweiten Zwischenträgerfrequenz 2x (f2-f1) enthalten.
Die Amplitude der Mischprodukte sinkt mit steigender Ordnung, d. h. die Amplitude des Mischprodukts der ersten Zwischenträgerfrequenz ist größer als die Amplitude des Mischprodukts der zweiten Zwischenträgerfrequenz. Mit Bezug auf Figuren 1a und 1b umfasst das erste Basisbandsignal das Mischsignal 21, d.h. Mischprodukte der ersten und zweiten Zwischenträgerfrequenzen sowie das erste und zweite Signal s1, s2. Das zweite Basisbandsignal 22a umfasst lediglich Mischprodukte der Zwischenträgerfrequenz f2-f1. In der Figur 2 sind von den Mischprodukten 22 lediglich die Mischprodukte 22 zu den Trägerfrequenzen f2-f1 und 2 x (f2-f1) dargestellt. Daten der Signale s1, s2 und den Mischprodukten 22 sind nicht nur auf der jeweiligen Trägerfrequenz sondern auch auf den Frequenzspektren, d.h. in Frequenzbereichen um die Trägerfrequenzen, enthalten. Das Signal des Mischprodukts 22 von 1 x f2-f1 ist nicht nur bei 50 MHz sondern in einem Spektrum von 47 bis 53 MHz enthalten.

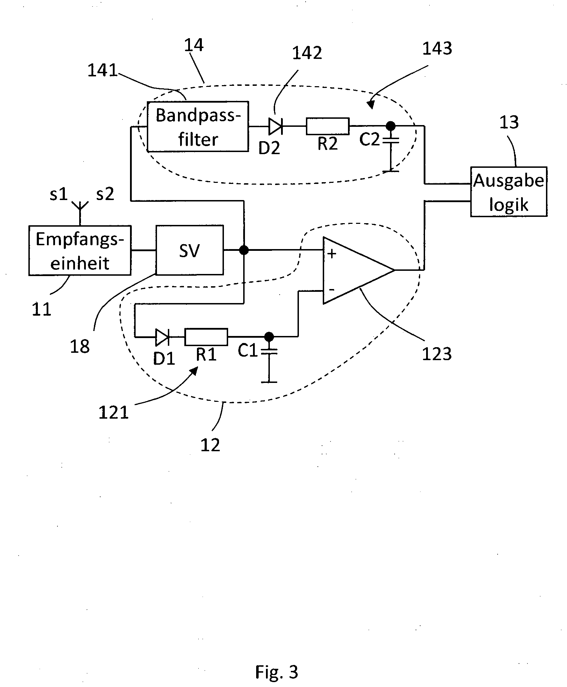

In der Figur 3 sind Schaltungsabschnitte des Ausführungsbeispiels aus Fig. 1a detaillierter dargestellt. Insbesondere sind in Figur 3 die erste und zweite Pegelanpassungseinheit 12,142 im Detail dargestellt.
Die erste Pegelanpassungseinheit 12 umfasst einen ersten Komparator 123 sowie einen Referenzwertgenerator 121. Der Referenzwertgenerator 121 weist eine erste Diode D1, einen ersten ohmschen Widerstand R1 und einen ersten Kondensator C1 auf. Die erste Diode D1 bewirkt einen Spannungsabfall des Ausgangssignals des ersten Spannungsvervielfachers 18 um ihre Schwellenspannung, z. B. 0,7V, auf eine erste Referenzspannung. Über den ersten ohmschen Widerstand R1 und den ersten Kondensator C1 wird die erste Referenzspannung geglättet und auf einen annährend konstanten Wert gehalten. Die geglättete erste Referenzspannung wird dem ersten Komparator 123 als Referenzwert zugeführt (negativer Eingang). Weiterhin wird der Ausgang des ersten Spannungsvervielfachers 18 direkt dem ersten Komparator 123 als Eingangssignal (positiver Eingang) zugeführt. Die erste Pegelanpassungseinheit 12 generiert, falls lediglich das erste Signal s1 empfangen wird, ein eindeutiges binäres Signal. Die Schwellenamplitude, d.h. der Grenzwert, zu dem ein eindeutiger 1-Pegel erkannt wird, kann über die Diode eingestellt werden. Am Ausgang der ersten Pegelanpassungseinheit 12 wird ein eindeutiger erster Bitstrom ausgegeben. In Abhängigkeit des Modulationsverfahrens kann alternativ die erste Referenzspannung auch dem positiven Eingang des ersten Komparators 123 zugeführt werden, wobei der negative Eingang mit dem Ausgang des ersten Spannungsvervielfachers 18 verbunden wird.
Sofern kein zweites Signal s2 von der Empfangseinheit 11 empfangen wird, wird das erste Signal s1 durch den Spannungsvervielfacher 18 gleichgerichtet und die Amplitude erhöht. Da es sich ausschließlich um ein einziges Signal mit einer Trägerfrequenz handelt, entstehen beim Spannungsvervielfacher 18 keine Mischprodukte. Das erste Signal s1 auf seiner Trägerfrequenz f1 liegt direkt am Eingang des ersten Komparators 123 an. Aus dem ersten Signal s1 wird mittels des Referenzwertgenerators 121 eine Gleichspannung als erster Referenzwert generiert, der um 0,7V (Schwellenspannung D1) unterhalb des Spitzenwerts des ersten Signals s1 liegt. Der erste Komparator 123 ist zur Auswertung eines Differenzwertes von wenigstens 0,4V ausgelegt. Dies bedeutet, dass bei einem Low-Pegel des ersten Signals s1 der Referenzwert aufrechterhalten bleibt und die Amplitude am Eingang des ersten Komparators kleiner ist als der erste Referenzwert. Der erste Komparator 123 folgt somit dem Signalverlauf des ersten Signals s1 und gibt den ersten Bitstrom aus.

Werden von der Empfangseinheit 11 sowohl das erste Signal s1 als auch das zweite Signal s2 empfangen, überlagern sich das erste Signal s1 und zweite Signal s2. Das Mischsignal weist einen Signalverlauf mit einer Änderung der Amplitude in unbekannter Höhe auf. Der erste Komparator 123 kann aus dem Mischsignal keinen sinnvollen ersten Bitstrom generieren. Als Folge liefert der erste Komparator einen Störwert. Der Störwert wird der Ausgabelogik 13 zugeführt.

Die zweite Pegelanpassungseinheit 142 kann analog zur ersten Pegelanpassungseinheit ausgeführt sein. Alternativ kann dem Frequenzfilter 141 lediglich eine Diode D2 als nicht-lineares Bauteil 142 mit der Funktion eines Mischers und eine Signalverarbeitungseinheit 143, beispielswiese ein zweiter ohmscher Widerstand R2 und ein zweiter Kondensator C2, nachgeschaltet werden. Beispielsweise mit der Signalverarbeitungseinheit 143 werden Störinhalte im zweiten Bitstrom gefiltert.

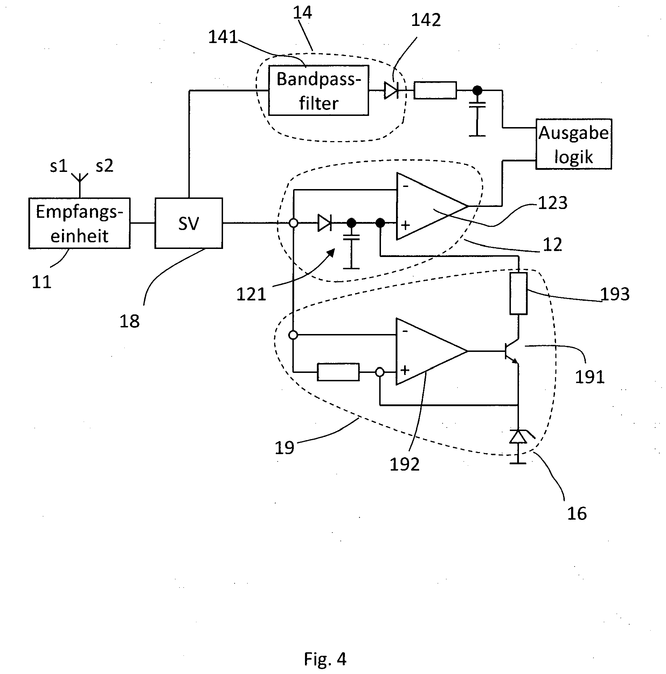

In der Figur 4 ist ein weiteres Ausführungsbeispiel der Erfindung dargestellt. Insbesondere handelt es sich um eine Erweiterung 19 der Schaltung aus Fig. 3. Im Detail handelt es sich um eine Anpassung des ersten Referenzwertes des ersten Komparators 123. Die Erweiterung 19 umfasst einen zweiten Komparator 192, einen elektronischen Schalter 191 sowie eine Konstantspannungsquelle 16.
Der positive Eingang des ersten Komparators 123 ist über einen dritten ohmschen Widerstand 193 mit dem elektronischen Schalter 191 (beispielsweise Collector-Eingang eines Transistors) verbunden. Weiterhin ist der elektronische Schalter 191 mit der Konstantspannungsquelle 16 verbunden. Der dritte ohmsche Widerstand 193 begrenzt den Stromfluss zur Konstantspannungsquelle 16. Der Ausgang des ersten Spannungsvervielfachers 18 ist mit dem negativen Eingang des zweiten Komparators 192 verbunden. Der positive Eingang des zweiten Komparators 192 ist über einen vierten ohmschen Widerstand 194 mit dem Ausgang des Spannungsvervielfachers 18 und direkt mit der Konstantspannungsquelle 16 verbunden. Die Konstantspannungsquelle 16 stellt eine konstante Spannung und einen zweiten Referenzwert für den zweiten Komparator 192 bereit, bspw. 0,4V. Der zweite Komparator 192 steuert über seinen Ausgang den elektronischen Schalter 191.
Empfängt die Empfangseinheit 11 das erste und zweite Signal s1, s2, liegt ein erster Referenzwert mit hoher Amplitude am ersten Komparator 123 an. Empfängt die Empfangseinheit 11 nur das erste Signal s1, generiert der Referenzwertgenerator 121 einen dazu relativ geringen ersten Referenzwert. Der erste Bitstrom am Ausgang des ersten Demodulators 123 entspricht dem Bitstrom des ersten Signals s1. Handelt es sich beim zweiten Signal s2 um ein Signal mit hohen Pegelwerten könnte bei Wegfallen bzw. Abfallen des zweiten Signals s2 der erste Referenzwert des Referenzwertgenerators 121 nicht schnell genug auf einen entsprechend der Amplitude des ersten Signals s1 passenden Referenzwert abfallen. Als Folge generiert der erste Demodulator 123 einen fehlerhaften ersten Bitstrom, bis der erste Referenzwert sich der Amplitude des ersten Referenzwertgenerators 121 angepasst hat. Eine Anpassung des Glättungsfaktors und/ oder der Kapazität des Referenzwertgenerators 121 könnte zu keinem befriedigendem Ergebnis führen.
Mithilfe der Erweiterung 19 erkennt der zweite Komparator 192, wann das erste und zweite Signal s1, s2 wegfallen bzw. ob das erste und zweite Signal s1, s2 von der Empfangseinheit 11 empfangen werden. Sobald das erste und zweite Signal s1, s2 nicht empfangen werden, sinkt der Pegel des Eingangssignals am negativen Eingang des zweiten Komparators 192 unter seinen zweiten Referenzwert bzw. die Spannung der Konstantspannungsquelle 16. Der zweite Komparator 192 liefert ein 1-Signal an den elektronischen Schalter 191. Der elektronische Schalter 191 stellt eine Verbindung zwischen dem ersten Referenzwert des ersten Komparators 123 und der Konstantspannungsquelle 16 her und gleicht den ersten Referenzwert an die Spannung der Konstantspannungsquelle 16 an. Ein zu hoher Pegel des ersten Referenzwertes am ersten Komparator 123 wird somit schnell auf einen niedrigen Pegel entsprechend der Konstantspannungsquelle 16 angeglichen.
Der erste Referenzwert des ersten Komparators 123 kann somit mit der Erweiterung 19 schnell auf ein dem ersten Signal s1 entsprechender Referenzwert angeglichen werden.

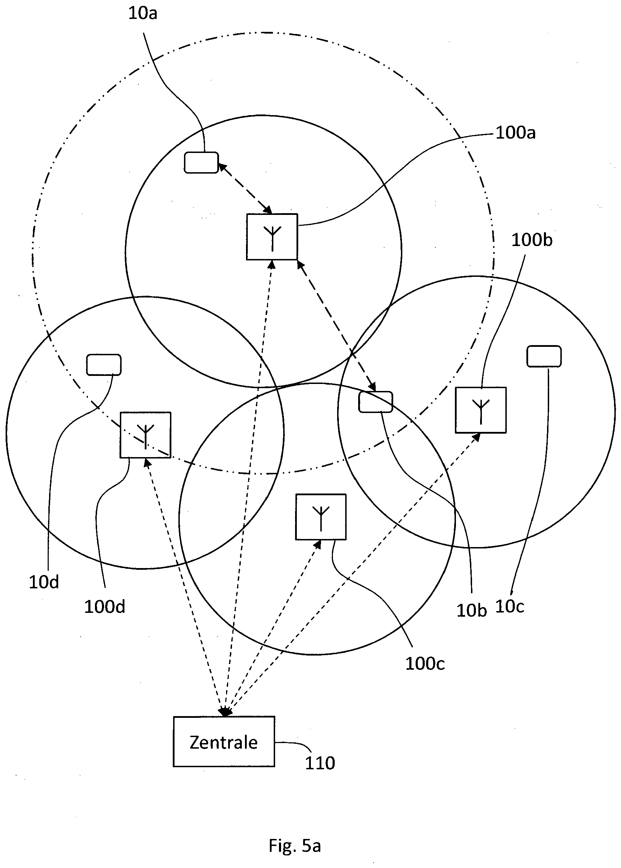

In Figur 5a ist ein Ausführungsbeispiel für eine Anwendung der Erfindung in UHF-RFID-Etiketten und -Tags zur Reichweitenerhöhung dargestellt.

Mehrere UHF-RFID-Sender 100a, 100b, 100c, 100d können jeweils von UHF-RFID-Etiketten 10a, 10b, 10c, 10d in einen bestimmten Umkreis (Kreise mit durchgezogener Linie um UHF-RFID-Sender 100a, 100b, a100c, 100d) Antworten empfangen. Die UHF-RFID-Etiketten 10a, 10b, 10c, 10d sind gemäß der Erfindung ausgestattet. Zur Kommunikation zwischen den UHF-RFID-Sendern 100a, 100b, 100c, 100d und den UHF-RFID-Etiketten 10a, 10b, 10c, 10d arbeiten die UHF-RFID-Etiketten 10a, 10b, 10c, 10d im elektromagnetischen Fernfeld, d. h. sie übermitteln Antworten mittels modulierter Rückstreuung. Die UHF-RFID-Etiketten 10a, 10b, 10c, 10d haben keine eigene Energieversorgung. Ihre Reichweite ist deshalb von dem elektromagnetischen Fernfeld abhängig. Das erste UHF-RFID-Etikett 10a kann im Feld des ersten UHF-RFID-Senders 100a mit diesem Kommunizieren. Eine Kommunikation des ersten UHF-RFID-Etiketts 10a mit dem zweiten/dritten/vierten UHF-RFID-Sender 10b, 10c, 10d ist aber grundsätzlich nicht möglich. Das zweite UHF-RFID-Etikett 10b ist im Kommunikationsbereich des zweiten und dritten UHF-RFID-Senders 100b, 100c und kann mit diesen kommunizieren. Das vierte UHF-RFID-Etikett 10d ist lediglich im Kommunikationsbereich mit dem vierten UHF-RFID-Sender 100d. Damit das zweite UHF-RFID-Etikett 10b mit dem ersten UHF-RFID-Sender 100a kommunizieren kann, muss dem zweiten UHF-RFID-Etikett 10b mehr Energie bereitgestellt werden. Dazu kann das zweite UHF-RFID-Etikett10b aus den elektromagnetischen Feldern der zweiten und dritten UHF-RFID-Sender 100b, 100c Energie entnehmen.

Der zweite und dritte UHF-RFID-Sender 100b, 100c senden jeweils ein unmoduliertes zweites und drittes Signal s2, s3 auf jeweils einer zweiten bzw. dritten Trägerfrequenz f2, f3. Der erste UHF-RFID-Sender 100a sendet eine Anfrage als moduliertes erstes Signal s1 auf einer ersten Trägerfrequenz f1 an das zweite UHF-RFID-Etikett 10b. Grundsätzlich liegen die erste, zweite und dritte Trägerfrequenz im gleichen Frequenzband und f1≠f2; f1≠f3; f1≈f2; f1≈f3. Das modulierte erste Signal s1 sowie die unmodulierten Signale s2, s3 werden vom zweiten UHF-RFID-Etikett 10b empfangen. Aufgrund der zusätzlichen zweiten und dritten Signale s2, s3, die sich mit dem ersten Signal s1 überlagern, werden im zweiten UHF-RFID-Etikett 10b Mischprodukte gebildet. Die Mischprodukte können zur weiteren Signalverarbeitung vom zweiten UHF-RFID-Etikett 10b genutzt werden. Der Energieinhalt des ersten, zweiten und dritten Signals s1, s2, s3 steht in Summe dem zweiten UHF-RFID-Etikett 10b zur Verfügung. Das zweite UHF-RFID-Etikett 10b empfängt das erste, zweite und dritte Signal s1, s2, s3 und generiert mithilfe der Erfindung einen Bitstrom des ersten Signals s1. Das zweite UHF-RFID-Etikett 10b erstellt eine erste Antwort.
Aufgrund der mehreren Signale, nämlich des ersten, zweiten und dritten Signal s1, s2, s3, erhält das zweite UHF-RFID-Etikett 10b eine, im Vergleich zu lediglich einem einzigen ersten Signal s1, höhere Energie zum Betrieb zur Verfügung. Die Rücksendereichweite ist grundsätzlich nicht erhöht. Aufgrund der Energie des ersten UHF-RFID-Senders 100a reicht diese aus, um das Rücksendesignals bzw. die erste Antwort auszuwerten. Befindet sich das zweite UHF-RFID-Etikett 10b außerhalb der Energiereichweite des ersten UHF-RFID-Senders 100a, jedoch innerhalb dessen Kommunikationsreichweite, kann durch zusätzlichen Energieeintrag des zweiten UHF-RFID-Senders 100b das zweite UHF-RFID-Etikett 100b mit ausreichend Energie beaufschlagt werden, um mit dem ersten UHF-RFID-Sender 100a zu kommunizieren. Aufgrund der zusätzlichen Energieversorgung des zweiten UHF-RFID-Etiketts 10b kann es Signale kleinerer Amplitude auswerten. Der Abstand zwischen dem ersten UHF-RFID-Sender 100a und zweiten UHF-RFID-Etikett 10b kann vergrößert werden (s. Strich-Doppelpunkt-Linie um ersten UHF-RFID-Sender 100a). Entsprechendes gilt für das vierte UHF-RFID-Etikett 10d in Verbindung unter Nutzung des vierten UHF-RFID-Senders 100d zur Kommunikation mit dem ersten UHF-RFID-Sender 100a.

Die Energiereichweite ist die Reichweite eines UHF-RFID-Senders, innerhalb dessen ein UHF-RFID-Etikett mit ausreichend Energie zu dessen Betrieb versorgt werden kann. Die Kommunikationsreichweite ist die Reichweite eines UHF-RFID-Etiketts, innerhalb der ein UHF-RFID-Etikett mit einem UHF-RFID-Sender kommunizieren könnte, sofern ausreichend Energie zum Betrieb des UHF-RFID-Etiketts das UHF-RFID-Etikett erhält. Die Energiereichweite ist in der Regel kleiner als die Kommunikationsreichweite.

Wie aus Fig. 5a ersichtlich, erreicht das elektromagnetische Fernfeld des zweiten UHF-RFID-Senders 100b das dritte UHF-RFID-Etikett 10c. Die Kommunikationsreichweite des ersten UHF-RFID-Senders 100a kann jedoch nicht ausreichend erhöht werden, damit das dritte UHF-RFID-Etikett 10c dem ersten UHF-RFID-Sender 100a antworten kann.

In Fig. 5a ist lediglich beispielhaft die Kommunikation ausgehend vom ersten UHF-RFID-Sender 100a dargestellt. Die Kommunikation kann entsprechend auf einen anderen UHF-RFID-Sender, bspw. dem zweiten, dritten und/oder vierten UHF-RFID-Sender 100b, 100c, 100d übertragen werden. Grundsätzlich ist zu beachten, dass nur ein UHF-RFID-Sender ein gültiges Kommunikationssignal, d. h. ein modulierte UHF-RFID-Signal, sendet. Andere Sender (gemäß Fig. 5a zweiter, dritter und vierter UHF-RFID-Sender 100b, 100c, 100d) senden vorzugsweise ein unmoduliertes Signal. Aufgrund unmodulierter Signale wird dem UHF-RFID-Etikett lediglich zusätzliche Energie bereitgestellt. Mithilfe der Erfindung kann das UHF-RFID-Etikett aus den überlagerten Signalen einen Bitstrom entsprechend dem modulierten Signal generieren. Sollten zwei UHF-RFID-Sender gleichzeitig ein dem UHF-RFID-Etikett erkennbare modulierte Signale senden, könnte das UHF-RFID-Etikett aus der Überlagerung der beiden modulierten Signale keinen Bitstrom generieren.

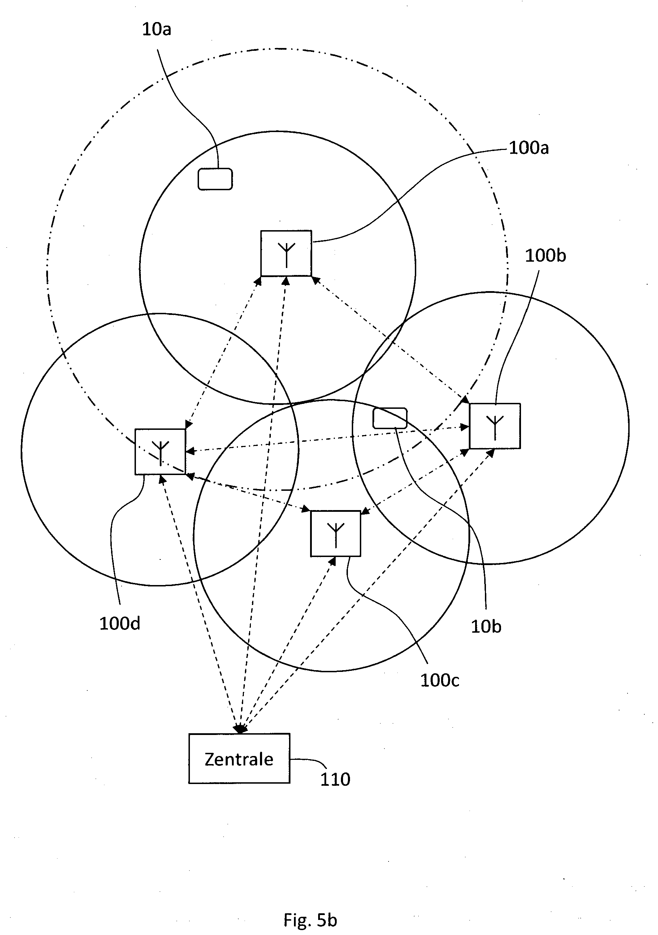

In Fig. 5b ist ein Ausführungsbeispiel einer Steuerung für die Reichweitenerhöhung gemäß Fig. 5a dargestellt. Eine Zentrale 110 steuert die UHF-RFID-Sender 100a, 100b, 100c, 100d. Die Zentrale 110 legt fest, welcher UHF-RFID-Sender 100a, 100b, 100c, 100d mit dem ersten und/ oder zweiten RFID-Etikett 10a, 10b (nur erstes und zweites RFID-Etikett 10a, 10b in Figur 5b dargestellt) kommunizieren darf. Insbesondere legt die Zentrale 110 fest, welcher UHF-RFID-Sender 100a, 100b, 100c, 100d ein für das erste und/ oder zweite RFID-Etikett 10a, 10b demodulierbares erstes Signal sendet und welcher der UHF-RFID-Sender 100a, 100b, 100c, 100d ein unmoduliertes bzw. ein für das erste und/ oder zweite UHF-RFID-Etikett nicht-demodulierbares Signal versenden. So sendet der erste UHF-RFID-Sender 100a ein für das erste RFID-Etikett 10a demodulierbares Signal, wogegen der zweite, dritte und vierte UHF-RFID-Sender 100b, 100c, 100d jeweils ein für das erste RFID-Etikett 10a unmoduliertes Signal sendet. Somit kann die Kommunikationsreichweite zwischen dem ersten UHF-RFID-Sender 100a und dem ersten RFID-Etikett 10a vergrößert werden. Analog sendet der vierte UHF-RFID-Sender 100d ein für das zweite RFID-Etikett 10b demodulierbares Signal, wogegen der erste, zweite und dritte UHF-RFID-Sender 100a, 100b, 100c jeweils ein für das zweite RFID-Etikett 10b unmoduliertes Signal sendet. Somit kann die Kommunikationsreichweite zwischen dem vierten UHF-RFID-Sender 100d und dem zweiten RFID-Etikett 10b vergrößert werden. Das System ist jedoch derart ausgestaltet, dass entweder der erste und vierte UHF-RFID-Sender 100a, 100d nicht gleichzeitig senden oder der erste und vierte UHF-RFID-Sender 100a, 100d jeweils ein Signal mit unterschiedlicher Modulationsart versenden.
Vorzugsweise weist die Zentrale 110 gezielt einen UHF-RFID-Sender 100a, 100b, 100c, 100d an. Alternativ können auch mehrere der ersten, zweiten, dritten und/ oder vierten UHF-RFID-Sender 100a, 100b, 100c, 100d zur Kommunikation mit dem ersten und/ oder zweiten UHF-RFID-Etikett 10a, 10b beauftragt werden, wobei der erste, zweite, dritte und/ oder vierte UHF-RFID-Sender 100a, 100b, 100c, 100d nicht gleichzeitig ein moduliertes Signal betreffend das erste und/ oder zweite UHF-RFID-Etikett 10a, 10b versenden. Zusätzlich zur Kommunikation kann eine räumliche Lokalisierung der ersten und/ oder zweiten UHF-RFID-Etiketten 10a, 10b durch Auswertung der Signal bezüglich der Trägerfrequenzen vorgenommen werden. Außer der Steuerung der UHF-RFID-Sender kann die Zentrale 110 die Funktion einer zentralen Kommunikationsstelle, z. B. Verteilzentrum aller Nachrichten, übernehmen.

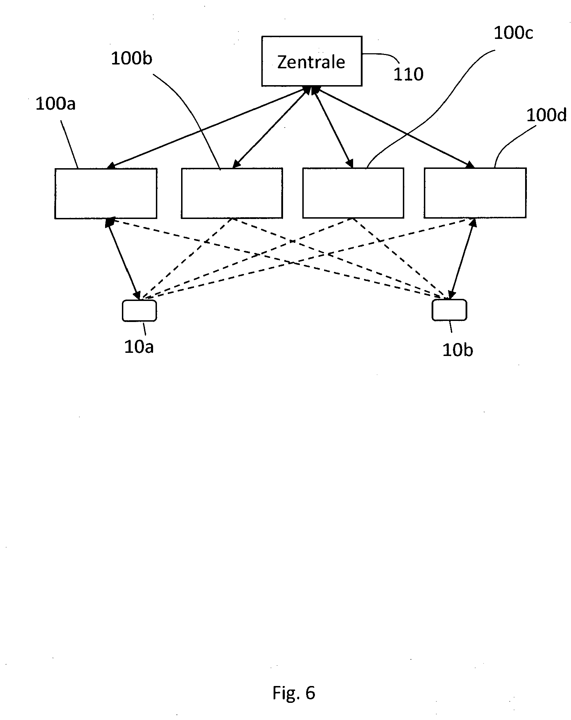

In der Figur 6 ist ein weiteres Anwendungsbeispiel der Erfindung dargestellt. Der räumliche Aufbau ist ähnlich der Figur 5a. Anstatt der Kommunikation zwischen einem UHF-RFID-Sender 100a, 100b, 100c, 100d und einem der UHF-RFID-Etiketten 10a, 10b, 10c, 10d wird in dieser Figur eine Kommunikation zwischen den UHF-RFID-Sender 100a, 100b, 100c, 100d untereinander betrachtet.

Zur Kommunikation zwischen UHF-RFID-Sender 100a, 100b, 100c, 100d und UHF-RFID-Etikett 10a, 10b, 10c sendet der betreffende bspw. der erste UHF-RFID-Sender 100a ein moduliertes Signal. Der zweite, dritte und vierte UHF-RFID-Sender 100b, 100c, 100d senden ein unmoduliertes Signal. Anstatt unmoduliertem Signal können der zweite, dritte und vierte UHF-RFID-Sender 100b, 100c, 100d ein Signal senden, das vom ersten, zweiten und dritten UHF-RFID-Etikett 10a, 10b, 10c nicht demodulierbar ist. Somit erscheint ein derartiges Signal ebenfalls als Störsignal bzw. als unmoduliertes Signal für das erste, zweite und dritte UHF-RFID-Etikett 10a, 10b, 10c. Dass ein Signal nicht demodulierbar ist, bedingt nicht, dass es zu 100% auf der Trägerfrequenz unmoduliert ist. Vielmehr kann das Signal Daten aufweisen, die mit einem für das UHF-RFID-Etikett unbekannten Modulationsverfahren oder Codierverfahren auf einer Trägerfrequenz moduliert sind. Während beispielsweise Daten zwischen dem ersten, zweiten, dritten und vierten UHF-RFID-Sender 100a, 100b, 100c, 100d und dem ersten, zweiten und dritten UHF-RFID-Etikett 10a, 10b, 10c mittels ASK-Modulation übertragen werden , kann der erste, zweite, dritte und/ oder vierte UHF-RFID-Sender 100a, 100b, 100c, 100d ein Signal mit FSK-Modulation versenden. Dieses Signal wäre für das erste, zweite oder dritte UHF-RFID-Etikett 10a, 10b, 10c nicht demodulierbar. Der erste, zweite, dritte und/ oder vierte UHF-RFID-Sender könnte zum Demodulieren eines mit FSK-Modulation moduliertes Signal ausgebildet sein. Ein Datenaustausch (Strich-Punkt-Linie) zwischen den UHF-RFID-Sendern 100a, 100b, 100c, 100d unter Anwendung einer FSK-Modulation kann stattfinden. Daten mittels FSK-Modulation sind für die UHF-RFID-Etiketten 10a, 10b, 10c, 10d nicht demodulierbar. Somit kann sichergestellt werden, dass die Kommunikation zwischen den UHF-RFID-Sendern 100a, 100b, 100c, 100d nicht von den UHF-RFID-Etiketten 10a, 10b, 10c, 10d verarbeitet wird. Die UHF-RFID-Sender 100a, 100b, 100c, 100d können beispielsweise Steuersignale untereinander senden, beispielsweise für eine Stand-By-Funktion oder eine Änderung der Trägerfrequenz. Eine Zentrale 110 überwacht und steuert zusätzlich die UHF-RFID-Sender 100a, 100b, 100c, 100d (strichlierte Linie).

Aus der Beschreibung und den Figuren kann entnommen werden, dass die Erfindung zur verbesserten Störverträglichkeit eines UHF-RFID-Geräts beiträgt. Störsignale, die im gleichen Frequenzband wie das gewünschte Datensignal empfangen werden, können einfach, in kleiner Bauweise und kostengünstig herausgefiltert werden. Zudem kann durch die Erfindung die Reichweite von UHF-RFID-Tags erhöht werden. Weiterhin kann eine Kommunikation zwischen UHF-RFID-Sendern stattfinden.

## Patentansprüche

1. Verfahren zum Erstellen eines Ausgabebitstromes (24) für ein erstes Signal (s1) einer ersten Trägerfrequenz durch ein Sicherheitsmodul, umfassend die folgenden Schritte im Sicherheitsmodul:
- Empfangen eines Eingangssignals (s), umfassend das erste Signal (s1) und ein zweites Signal (s2) einer zweiten Trägerfrequenz, wobei das erste und zweite Signal (s1, s2) zusammen empfangen werden
- Demodulieren des Eingangssignals (s) durch ein erstes nichtlineares Bauteil (18), wobei das erste nichtlineare Bauteil ein erstes Basisbandsignal ausgibt;
- Generieren eines ersten Bitstromes (20b) aus dem Basisbandsignal;
- Zuführen des ersten Bitstromes (20b) einer Ausgabelogik (13); und
- Bilden eines Mischsignals (21), welches das erste Signal (s1) auf der ersten Trägerfrequenz, das zweite Signal (s2) auf der zweiten Trägerfrequenz, und ein Mischprodukt (22) auf einer Zwischenfrequenz aufweist;
**gekennzeichnet durch** die Schritte
- Demodulieren des Mischprodukts (22) durch ein zweites nichtlineares Bauteil (144) zur Ausgabe eines zweiten Basisbandsignals (22a) zum Generieren eines zweiten Bitstromes (23) betreffend das erste Signal (s1) im Mischprodukt (22); und
- Erstellen des Ausgabebitstromes (24) für das erste Signal (s1) durch die Ausgabelogik (13), wobei die Ausgabelogik (13) entweder den ersten Bitstrom (20b) oder den zweiten Bitstrom (23) als Ausgabebitstrom für das erste Signal auswählt.

2. Verfahren nach Anspruch 1, **dadurch gekennzeichnet, dass** die Ausgabelogik (13) den ersten Bitstrom (20b) mit dem zweiten Bitstrom (23) kombiniert.

3. Verfahren nach einem der vorhergehenden Ansprüche, **dadurch gekennzeichnet, dass** das Mischsignal (21) mithilfe eines ersten Frequenzfilters (141) gefiltert wird, das erste Frequenzfilter (141) das Mischprodukt (22a) ausgibt und das erste Frequenzfilter (141) auf die Zwischenfrequenz ausgelegt ist.

4. Verfahren nach einem der vorhergehenden Ansprüche, **dadurch gekennzeichnet, dass** das erste und/ oder zweite nichtlineare Bauteil (18, 144) eine Amplitude des Eingangssignals erhöht und/ oder die Funktion eines Mischers und/ oder eines Demodulators aufweist.

5. Verfahren nach einem der vorhergehenden Ansprüche, **dadurch gekennzeichnet, dass** eine erste und/ oder zweite Pegelwertanpassungseinheit (12, 142) den ersten bzw. zweiten Bitstrom (20b, 23) basierend auf einen ersten bzw. zweiten Referenzwert anpasst.

6. Verfahren nach Anspruch 5, **dadurch gekennzeichnet, dass** die erste und/ oder zweite Pegelwertanpassungseinheit (12, 142) den ersten bzw. zweiten Referenzwert an die Amplitude des ersten bzw. zweiten Basisbandsignals (22a) anpasst.

7. Verfahren nach Anspruch 5 oder 6, **dadurch gekennzeichnet, dass** der erste und/ oder zweite Referenzwert in Abhängigkeit des Mischsignals (21) und/ oder des ersten Signals (s1) und/ oder des zweiten Signals (s2) angepasst wird.

8. Verfahren nach einem der vorhergehenden Ansprüche, **dadurch gekennzeichnet, dass** der erste Bitstrom (20b) während des Empfangs des zweiten Signals (s2) einen Störwert (25) aufweist, wobei die Ausgabelogik (13) vom ersten Bitstrom (20b) auf den zweiten Bitstrom (23) wechselt, wenn die Ausgabelogik (13) den Störwert (25) erkennt.

9. Verfahren nach einem der vorhergehenden Ansprüche, **dadurch gekennzeichnet, dass** ein Sensor der Ausgabelogik (13) den ersten und/ oder zweiten Bitstrom (20b, 23) analysiert.

10. Verfahren nach einem der vorhergehenden Ansprüche, **dadurch gekennzeichnet, dass** das Sicherheitsmodul das zweite Signal (s2) zur Energieversorgung verwendet.

11. Verfahren nach einem der vorhergehenden Ansprüche, **dadurch gekennzeichnet, dass** das Sicherheitsmodul eine Empfangseinheit (11) umfasst, wobei die Empfangseinheit die Trägerfrequenz des ersten Signals (s1) und des zweiten Signals (s2) im Empfangsbereich der Empfangseinheit (11) empfängt.

12. Sicherheitsmodul umfassend eine Empfangseinheit (11) zum Empfangen eines Eingangssignals, umfassend ein erstes Signal (s1) einer ersten Trägerfrequenz und ein zweites Signal (s2) einer zweiten Trägerfrequenz, ein erstes nichtlineare Bauteil (18) und eine erste Pegelwertanpassungseinheit (12), wobei das erste nichtlineare Bauteil (18) ausgebildet ist, aus dem ersten Signal (s1) und dem zweiten Signal (s2) ein Mischsignal (21) mit einem ersten Basisbandsignal zu bilden, wobei die Pegelwertanpassungseinheit (12) ausgebildet ist, aus dem ersten Basisbandsignal einen ersten Bitstrom (20b) zu generieren; **dadurch gekennzeichnet, dass**
das Sicherheitsmodul ein erstes Frequenzfilter (141), ein zweites nichtlineares Bauteil (144), eine zweite Pegelwertanpassungseinheit (142) und eine Ausgabelogik (13) umfasst, wobei das erste Frequenzfilter (141) ausgebildet ist, aus dem Mischsignal (21) ein Mischprodukt (22) zu filtern; das zweite nichtlineare Bauteil (144) ausgebildet ist, das Mischprodukt (22) zu demodulieren und wobei die zweite Pegelwertanpassungseinheit (142) ausgebildet ist einen zweiten Bitstrom (23) zu generieren; und die Ausgabelogik (13) einen Eingang für den ersten Bitstrom (20b) und einen Eingang für den zweiten Bitstrom (23) aufweist, und die Ausgabelogik (13) zum Wechseln zwischen dem ersten und dem zweiten Bitstrom (20b, 23) ausgebildet ist und ausgebildet ist, aus dem ersten und zweiten Bitstrom (20b, 23) einen Bitstrom des ersten Signals (24) zu bilden.

13. Sicherheitsmodul nach Anspruch 12, **dadurch gekennzeichnet, dass** das erste/ zweite nichtlineare Bauteil (18,144) als Mischer, zur Erhöhung der Amplitude des Eingangssignals (s) bzw. des Mischprodukts (22), und/ oder zur Demodulation des ersten Signals (s1) bzw. des Mischprodukts (22) ausgebildet ist.

14. Sicherheitsmodul nach Anspruch 12 oder 13, **dadurch gekennzeichnet, dass** das Sicherheitsmodul zum Durchführen eines Verfahrens nach einem der Ansprüche 1 bis 11 ausgebildet ist.

15. System zum Erstellen eines Bitstromes eines ersten Signals einer ersten Trägerfrequenz eines Sende-/ Empfangsgeräts (100a, 100b, 100c, 100d), wobei das System ein Sicherheitsmodul nach einem der Ansprüche 12 bis 14 umfasst und/ oder zur Durchführung eines Verfahrens nach einem der Ansprüche 1 bis 11 ausgebildet ist.

## Claims

1. A method for producing an output bit stream (24) for a first signal (s1) of a first carrier frequency by a security module, comprising the following steps in the security module:
- receiving an input signal (s) comprising the first signal (s1) and a second signal (s2) of a second carrier frequency, wherein the first and second signals (s1, s2) are received together,
- demodulating the input signal (s) by a first nonlinear component, wherein the first nonlinear component outputs a first baseband signal;
- generating a first bit stream (20b) from the baseband signal;
- feeding the first bit stream (20b) to an output logic (13); and
- forming a mixed signal (21) having the first signal (s1) at the first carrier frequency, the second signal (s2) at the second carrier frequency, and a mixed product (22) at an intermediate frequency;
**characterized by** the steps of
- demodulating the mixed product (22) by a second nonlinear component (144) for outputting a second baseband signal (22a) for generating a second bit stream (23) relating to the first signal (s1) in the mixed product (22); and
- producing the output bit stream (24) for the first signal (s1) by the output logic (13), wherein the output logic (13) selects either the first bit stream (20b) or the second bit stream (23) as the output bit stream for the first signal.

2. The method according to claim 1, **characterized in that** the output logic (13) combines the first bit stream (20b) with the second bit stream (23).

3. The method according to any of the preceding claims, **characterized in that** the mixed signal (21) is filtered with the aid of a first frequency filter (141), the first frequency filter (141) outputs the mixed product (22a) and the first frequency filter (141) is laid out for the intermediate frequency.

4. The method according to any of the preceding claims, **characterized in that** the first and/or second nonlinear component (18, 144) increases an amplitude of the input signal and/or has the function of a mixer and/or of a demodulator.

5. The method according to any of the preceding claims, **characterized in that** a first and/or second level-value adjusting unit (12, 142) adjusts the first and/or second bit stream (20b, 23) on the basis of a first and/or second reference value.

6. The method according to claim 5, **characterized in that** the first and/or second level-value adjusting unit (12, 142) adjusts the first and/or second reference value to the amplitude of the first and/or second baseband signal (22a).

7. The method according to claim 5 or 6, **characterized in that** the first and/or second reference value is adjusted in dependence on the mixed signal (21) and/or the first signal (s1) and/or the second signal (s2).

8. The method according to any of the preceding claims, **characterized in that** the first bit stream (20b) has an interference value (25) during the reception of the second signal (s2), wherein the output logic (13) switches from the first bit stream (20b) to the second bit stream (23) when the output logic (13) detects the interference value (25).

9. The method according to any of the preceding claims, **characterized in that** a sensor of the output logic (13) analyzes the first and/or second bit stream (20b, 23).

10. The method according to any of the preceding claims, **characterized in that** the security module employs the second signal (s2) for supplying energy.

11. The method according to any of the preceding claims, **characterized in that** the security module comprises a receiving unit (11), wherein the receiving unit receives the carrier frequency of the first signal (s1) and of the second signal (s2) in the reception range of the receiving unit (11).

12. A security module comprising a receiving unit (11) for receiving an input signal comprising a first signal (s1) of a first carrier frequency and a second signal (s2) of a second carrier frequency, a first nonlinear component (18) and a first level-value adjusting unit (12), wherein the first nonlinear component (18) is adapted to form a mixed signal (21) from the first signal (s1) and the second signal (s2) with a first baseband signal, wherein the level-value adjusting unit (12) is adapted to generate a first bit stream (20b) from the first baseband signal; **characterized in that**
the security module comprises a first frequency filter (141), a second nonlinear component (144), second level-value adjusting unit (142) and an output logic (13), wherein the first frequency filter (141) is adapted to filter a mixed product (22) from the mixed signal (21); the second nonlinear component (144) is adapted to demodulate the mixed product (22) and wherein the second level-value adjusting unit (142) is adapted to generate a second bit stream (23); and the output logic (13) has an input for the first bit stream (20b) and an input for the second bit stream (23), and the output logic (13) is adapted to switch between the first and the second bit stream (20b, 23) and is adapted to form a bit stream of the first signal (24) from the first and second bit stream (20b, 23).

13. The security module according to claim 12, **characterized in that** the first/ second nonlinear component (18, 144) is adapted as a mixer, for increasing the amplitude of the input signal (s) and/or of the mixed product (22), and/or for demodulating the first signal (s1) and/or the mixed product (22).

14. The security module according to claim 12 or 13, **characterized in that** the security module is adapted to carry out a method according to any of claims 1 to 11.

15. A system for producing a bit stream of a first signal of a first carrier frequency of a transmitting/ receiving device (100a, 100b, 100c, 100d), wherein the system comprises a security module according to any of claims 12 to 14 and/or is adapted to carry out a method according to any of claims 1 to 11.

## Revendications

1. Procédé de production d'un flux de bits de sortie (24) pour un premier signal (s1) d'une première fréquence porteuse, par un module de sécurité, comprenant les étapes suivantes dans le module de sécurité :
- réception d'un signal d'entrée (s) comprenant le premier signal (s1) et un deuxième signal (s2) d'une deuxième fréquence porteuse, le premier et le deuxième signal (s1, s2) étant reçus ensemble
- démodulation du signal d'entrée (s) par un premier composant non linéaire (18), le premier composant non linéaire émettant un premier signal en bande de base ;
- génération d'un premier flux de bits (20b) à partir du signal en bande de base ;
- acheminement du premier flux de bits (20b) à une logique de sortie (13) ;
et
- constitution d'un signal mélangé (21) qui comporte le premier signal (s1) à la première fréquence porteuse, le deuxième signal (s2) à une deuxième fréquence porteuse, et un produit mélangé (22) à une fréquence intermédiaire ;
**caractérisé par** les étapes
- démodulation du produit mélangé (22) par un deuxième composant non linéaire (144) pour la sortie d'un deuxième signal de bande de base (22a) pour la génération d'un deuxième flux de bits (23) concernant le premier signal (s1) dans le produit mélangé (22) ; et
- production du flux de bits de sortie (24) pour le premier signal (s1), par la logique de sortie (13), la logique de sortie (13) sélectionnant soit le premier flux de bits (20b), soit le second flux de bits (23) comme flux de bits de sortie pour le premier signal.

2. Procédé selon la revendication 1, **caractérisé en ce que** la logique de sortie (13) combine le premier flux de bits (20b) au second flux de bits (23).

3. Procédé selon une des revendications précédentes, **caractérisé en ce que** le signal mélangé (21) est filtré à l'aide d'un premier filtre de fréquence (141), que le premier filtre de fréquence (141) émet le produit mélangé (22a) et que le premier filtre de fréquence (141) est réglé sur la fréquence intermédiaire.

4. Procédé selon une des revendications précédentes, **caractérisé en ce que** le premier et/ou le deuxième composant non linéaire (18, 144) augmente une amplitude du signal d'entrée et/ou la fonction d'un mélangeur et/ou d'un démodulateur.

5. Procédé selon une des revendications précédentes, **caractérisé en ce que** la première et/ou la deuxième unité d'ajustement de valeur de niveau (12, 142) ajuste le flux de bits (20b, 23) sur la base d'une première ou deuxième valeur de référence.

6. Procédé selon la revendication 5, **caractérisé en ce que** la première et/ou la deuxième unité d'ajustement de valeur de niveau (12, 142) ajuste la première ou la deuxième valeur de référence sur l'amplitude du premier ou du deuxième signal de bande de base (22a).

7. Procédé selon la revendication 5 ou 6, **caractérisé en ce que** la première et/ou la deuxième valeur de référence est ajustée en fonction du signal mélangé (21) et/ou du premier signal (s1) et/ou du deuxième signal (s2).

8. Procédé selon une des revendications précédentes, **caractérisé en ce que** le premier flux de bits (20b) présente, durant la réception du deuxième signal (s2), une valeur de défaut (25), cependant que la logique de sortie (13) commute du premier flux de bits (20b) au deuxième flux de bits (23) quand la logique de sortie (13) reconnaît la valeur de défaut (25).

9. Procédé selon une des revendications précédentes, **caractérisé en ce qu'**un capteur de la logique de sortie (13) analyse le premier et/ou le deuxième flux de bits (20b, 23).

10. Procédé selon une des revendications précédentes, **caractérisé en ce que** le module de sécurité utilise le deuxième signal (s2) pour l'alimentation en énergie.

11. Procédé selon une des revendications précédentes, **caractérisé en ce que** le module de sécurité comprend une unité de réception (11), cependant que l'unité de réception reçoit la fréquence porteuse du premier signal (s1) et du deuxième signal (s2) dans la zone de réception de l'unité de réception (11).

12. Module de sécurité comprenant une unité de réception (11) pour la réception d'un signal d'entrée, comprenant un premier signal (s1) d'un première fréquence porteuse et un deuxième signal (s2) d'une deuxième fréquence porteuse, un premier composant non linéaire (18) et une première unité d'ajustement de valeur de niveau (12), cependant que le premier composant non linéaire (18) est conçu pour, à partir du premier signal (s1) et du deuxième signal (s2), constituer un signal mélangé (21) avec un premier signal en bande de base, cependant que l'unité d'ajustement de valeur de niveau (12) est conçue pour, à partir du premier signal en bande de base, générer un premier flux de bits (20b) ;
**caractérisé en ce que**
le module de sécurité comprend un premier filtre de fréquence (141), un deuxième composant non linéaire (144), une deuxième unité d'ajustement de valeur de niveau (142) et une logique de sortie (13), cependant que le premier filtre de fréquence (141) est conçu pour, à partir du signal mélangé (21), filtrer un produit mélangé (22) ; le deuxième composant non linéaire (144) est conçu pour démoduler le produit mélangé (22), et cependant que la deuxième unité d'ajustement de valeur de niveau (142) est conçue pour générer un deuxième flux de bits (23) ; et la logique de sortie (13) comporte un entrée pour le premier flux de bits (20b) et un entrée pour le deuxième flux de bits (23), et la logique de sortie (13) est conçue pour commuter entre le premier flux de bits et le deuxième flux de bits (20b, 23), et est conçue pour, à partir du premier et du deuxième flux de bits (20b, 23), constituer un flux de bits du premier signal (24).

13. Module de sécurité selon la revendication 12, **caractérisé en ce que** le premier/deuxième composant non linéaire (18, 144) est conçu en tant que mélangeur pour l'augmentation de l'amplitude du signal d'entrée (s) et/ou du produit mélangé (22), et/ou pour la démodulation du premier signal (s1) et/ou du produit mélangé (22).

14. Module de sécurité selon la revendication 12 ou 13, **caractérisé en ce que** le module de sécurité est conçu pour l'exécution d'un procédé selon une des revendications de 1 à 11.

15. Système de production d'un flux de bits d'un premier signal d'une première fréquence porteuse d'un appareil d'émission/de réception (100a, 100b, 100c, 100d), cependant que le système comprend un module de sécurité selon une des revendications de 12 à 14 et/ou est conçu pour l'exécution d'un procédé selon une des revendications de 1 à 11.
